# EUROPEAN PATENT APPLICATION

(11) **EP 4 576 995 A2**
(43) Date of publication of application: **25.06.2025**
(21) Application number: 24207025.8
(22) Date of filing: 16.10.2024
(51) Int. Cl.: H10D 84/01, H10D 84/83

(54) **INTEGRATED CIRCUIT DEVICE WITH BACKSIDE ISOLATON REGION**

(30) Priority: 20.12.2023 US 202318390641
(71) Applicant: INTEL Corporation, Santa Clara, CA 95054 (US)
(72) Inventor: MURTHY, Anand, Portland, 97229 (US); LIN, Chia-Ching, Portland, 97229 (US); LUO, Yanbin, Portland, 97229 (US); JANG, Minwoo, Portland, 97229 (US); ZHANG, Yang, New Mexico, 87124 (US); CHU, Tao, Portland, 97229 (US); HUNG, Ting-Hsiang, Beaverton, 97007 (US); HUANG, Chiao-Ti, Porland, 97229 (US); ZHANG, Feng, Portland, 97123 (US); CHAO, Robin, Portland, 97209 (US); XU, Guowei, Portland, 97229 (US); ZHANG, Kan, Hillsboro, 97123 (US)
(74) Representative: HGF

(57) **Abstract**

An IC device may have active regions and one or more isolation regions. The IC device includes gates that are in parallel. One or more semiconductor structures (e.g., fins, nanoribbons, etc.) may extend across each gate in the IC device. Some of the gates are in the active regions. The other gates are in the isolation region. A gate in an active region may be between semiconductor regions, which may function as the source region and drain region of a transistor. A gate in an isolation region may be between insulator regions. The insulator regions may be formed from the backside of the IC device. For instance, semiconductor regions may be formed in both the active regions and the isolation regions. The semiconductor regions in the regions designated to be isolation regions may be removed from the backside and filled with one or more electrical insulators.

## Description

### Background

Integrated circuit (IC) fabrication usually includes two stages. The first stage is referred to as the front end of line (FEOL). The second stage is referred to as the back end of line (BEOL). In the FEOL, individual semiconductor devices components (e.g., transistor, capacitors, resistors, etc.) can be patterned in a wafer. Non-functional regions may also be formed between functional devices in the FEOL. Non-functional regions may be used to isolate the functional devices from each other. Such non-functional regions are also referred to as isolation regions. In the BEOL, metal layers, vias, and insulating layers can be formed to get the individual components interconnected. Metal layers can be arranged at both the frontside and the backside of the semiconductor devices. Functional devices may be coupled to metal layers, e.g., a metal layer used as power plane, ground plane, or signal plane.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 illustrates an IC device comprising isolation regions, according to some embodiments of the disclosure.
FIG. 2 illustrates an IC device including an isolation region formed through semiconductor removal, according to some embodiments of the disclosure.
FIG. 3 illustrates an IC device with non-uniform semiconductor structures, according to some embodiments of the disclosure.
FIG. 4 illustrates an IC device with uniform semiconductor structures, according to some embodiments of the disclosure.
FIGS. 5A-5L illustrate a process of fabricating an IC device with backside isolation regions, according to some embodiments of the disclosure.
FIG. 6 shows a transistor with nanoribbons, according to some embodiments of the disclosure.
FIGS. 7A-7B are top views of a wafer and dies, according to some embodiments of the disclosure.
FIG. 8 is a side, cross-sectional view of an example IC package that may include one or more IC devices with backside isolation regions, according to some embodiments of the disclosure.
FIG. 9 is a cross-sectional side view of an IC device assembly that may include components having one or more IC devices with backside isolation regions, according to some embodiments of the disclosure.
FIG. 10 is a block diagram of an example computing device that may include one or more components with backside isolation regions, according to some embodiments of the disclosure.

### Detailed Description

The systems, methods, and devices of this disclosure each have several innovative aspects, no single one of which is solely responsible for all the desirable attributes disclosed herein. Details of one or more implementations of the subject matter described in this specification are set forth in the description below and the accompanying drawings.

Many IC devices include a large array of semiconductor devices, e.g., transistors. Examples of transistors in these circuit devices include metal-oxide-semiconductor field-effect transistor (MOSFET), such as N-type metal-oxide-semiconductor (NMOS) FET (field-effect transistor), P-type metal-oxide-semiconductor (PMOS) FET, and so on. Continued scaling of transistors creates challenges for forming isolation regions between adjacent transistors. An isolation region may be located between two neighboring transistors for isolating the two transistors from each other. Source or drain regions are typically not formed in isolation regions. Currently available approaches for fabricating isolation regions usually require cutting semiconductor structures (e.g., fins, nanoribbons, etc.) in isolation regions, which may be done even before gates in the isolation regions are formed. Such approaches can cause with-in die (WID) variations in the downstream process. Gate profile and wafer topography can be impacted. For instance, gates for continuous semiconductor structures (e.g., gates in active transistors) can have different profiles from gates for cut off semiconductor structures. WID variations can result in yield issues, such as gate etch out over the isolation region. The yield issues can significantly impact the performance of the IC device.

Embodiments of the present disclosure may improve on at least some of the challenges and issues described above by providing IC devices with backside isolation regions. An example backside isolation region in an IC device may be formed by removing a semiconductor region between two gates in the IC device from the backside of the IC device. This approach of forming isolation regions would avoid non-uniform semiconductor structures (e.g., fins, nanoribbons, etc.) across gates. Compared with currently available IC devices, IC devices in the present disclosure can suffer from less or even no WID variations and therefore, can have better performance.

In various embodiments of the present disclosure, An IC device may have active regions and one or more isolation regions. An active region may include one or more active devices, such as transistors. An isolation region may be adjacent to an active region and isolate the active region from one or more other active regions in the IC devices. For instance, an isolation region may be between two active regions and isolate the two active regions from each other. The IC device may include gates stacked in a direction. One or more semiconductor structures (e.g., fins, nanoribbons, etc.) may extend across each gate in the IC device. Some of the gates are in the active regions. The other gates are in the isolation region. A gate in an active region may be between semiconductor regions in the first direction. The semiconductor regions may be the source region and drain region, respectively, of a transistor including the gate. A gate in an isolation region may be between insulator regions. The insulator regions may be over the semiconductor regions in the direction. In some cases, the insulator regions may be parallel to the semiconductor regions. The IC device may also include electrodes. An electrode may be over a semiconductor region in an active region or over an insulator region in an isolation region in another direction that is perpendicular to the direction.

To form the IC device, a device including a plurality of gates, semiconductor structures, semiconductor regions, and electrodes may be formed. One or more of the semiconductor structures may extend across a gate. The gate may be between two semiconductor regions. An electrode may be over the semiconductor regions. The device may also include a support structure that includes a semiconductor material. The device may have a frontside and a backside. One or more metal layers may be formed at the frontside. The gates and electrodes may be between the one or more metal layers and the support structure. The support structure may be removed from the backside. After the support structure is removed, a hard mask may be formed over the device. The hard mask may be patterned to block semiconductor regions in portions of the device that are designated to be active regions and to expose semiconductor regions in portions of the device that are designated to be isolation regions. The semiconductor regions in the portions of the device that are designated to be isolation regions may be removed from the backside to form opening regions. The opening regions may be filled with one or more electrical insulators to form insulator regions. After the insulator regions are formed, one or more metal layers may be formed at the backside.

It should be noted that, in some settings, the term "nanoribbon" has been used to describe an elongated semiconductor structure that has a substantially rectangular transverse cross-section (e.g., a cross-section in a plane perpendicular to the longitudinal axis of the structure), while the term "nanoribbon" has been used to describe a similar structure but with a substantially circular or square transverse cross-sections. In the following, a single term "nanoribbon" is used to describe an elongated semiconductor structure independent of the shape of the transverse cross-section. Thus, as used herein, the term "nanoribbon" is used to cover elongated semiconductor structures that have substantially rectangular transverse cross-sections (possibly with rounded corners), elongated semiconductor structures that have substantially square transverse cross-sections (possibly with rounded corners), elongated semiconductor structures that have substantially circular or elliptical/oval transverse cross-sections, as well as elongated semiconductor structures that have any polygonal transverse cross-sections.

In the following, some descriptions may refer to a particular source or drain (S/D) region or contact being either a source region/contact or a drain region/contact. However, unless specified otherwise, which region/contact of a transistor or diode is considered to be a source region/contact and which region/contact is considered to be a drain region/contact is not important because, as is common in the field of FETs, designations of source and drain are often interchangeable. Therefore, descriptions of some illustrative embodiments of the source and drain regions/contacts provided herein are applicable to embodiments where the designation of source and drain regions/contacts may be reversed.

As used herein, the term "metal layer" may refer to a layer above a substrate that includes electrically conductive interconnect structures for providing electrical connectivity between different IC components. Metal layers described herein may also be referred to as "interconnect layers" to clearly indicate that these layers include electrically conductive interconnect structures which may, but do not have to be, metal.

The systems, methods and devices of this disclosure each have several innovative aspects, no single one of which is solely responsible for all of the desirable attributes disclosed herein. Details of one or more implementations of the subject matter described in this specification are set forth in the description below and the accompanying drawings.

In the following detailed description, various aspects of the illustrative implementations may be described using terms commonly employed by those skilled in the art to convey the substance of their work to others skilled in the art. For example, the term "connected" means a direct electrical or magnetic connection between the things that are connected, without any intermediary devices, while the term "coupled" means either a direct electrical or magnetic connection between the things that are connected, or an indirect connection through one or more passive or active intermediary devices. The term "circuit" means one or more passive and/or active components that are arranged to cooperate with one another to provide a desired function. If used, the terms "oxide," "carbide," "nitride," etc. refer to compounds containing, respectively, oxygen, carbon, nitrogen, etc., the term "high-k dielectric" refers to a material having a higher dielectric constant (k) than silicon oxide, while the term "low-k dielectric" refers to a material having a lower k than silicon oxide. The terms "substantially," "close," "approximately," "near," and "about," generally refer to being within +/- 10%, e.g., within +/- 5% or within +/- 2%, of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 8% of a target value, e.g., within +/- 5% of a target value or within +/- 2% of a target value, based on the context of a particular value as described herein or as known in the art. Also, the term "or" refers to an inclusive "or" and not to an exclusive "or."

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening layers.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. As used herein, the notation "A/B/C" means (A), (B), and/or (C).

The description may use the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

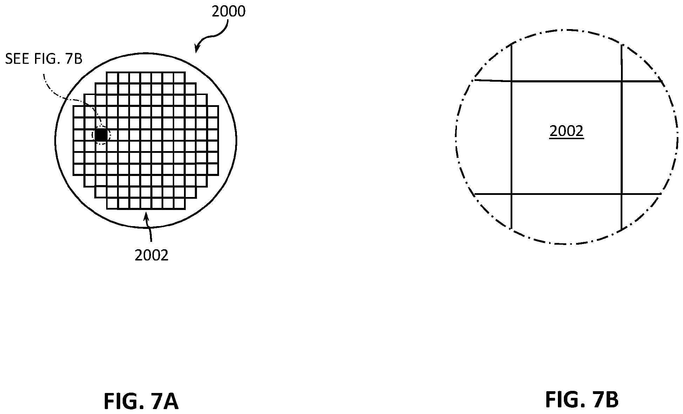

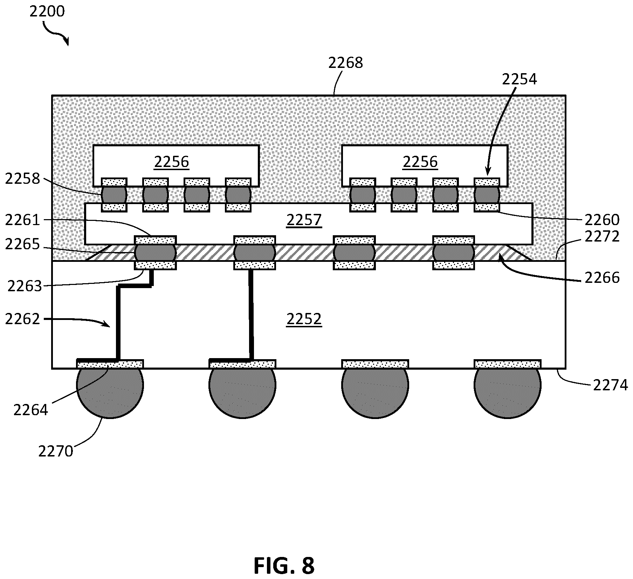

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense. For convenience, if a collection of drawings designated with different letters are present, e.g., FIGS. 7A-7B, such a collection may be referred to herein without the letters, e.g., as "FIG. 8."

In the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of semiconductor devices with semiconductor structures extending across gates in isolation regions as described herein.

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

Various IC devices with backside isolation regions as described herein may be implemented in, or associated with, one or more components associated with an IC or/and may be implemented between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

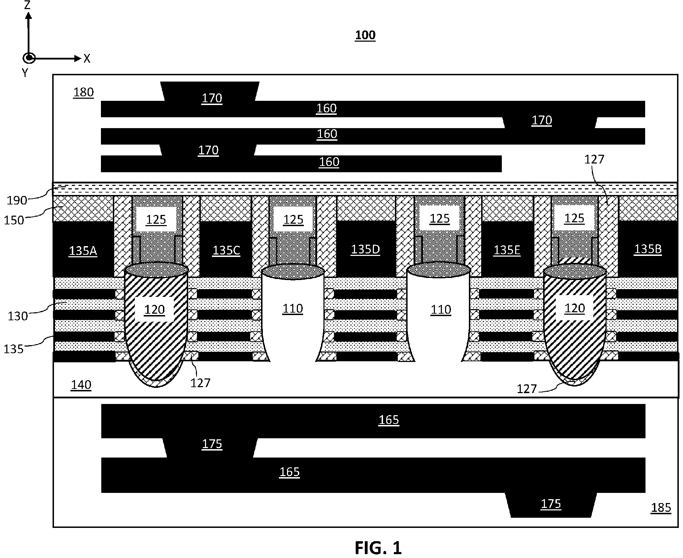

FIG. 1 illustrates an IC device 100 comprising isolation regions 110, according to some embodiments of the disclosure. In some embodiments, the IC device 100 may be formed through a complementary metal-oxide semiconductor (CMOS) fabrication process. For the purpose of illustration, FIG. 1 shows a cross-sectional view of the IC device 100 in the X-Z plane. The IC device 100 also includes semiconductor structures 120 (individually referred to as "semiconductor structure 120"), electrodes 125 (individually referred to as "electrode 125"), dielectric structures 127 (individually referred to as "dielectric structure 127"), semiconductor structures 130 (individually referred to as "semiconductor structure 130"), gates 135A-135E (collectively referred to as "gates 135" or "gate 135"), an electrical insulator 140, spacers 150 (individually referred to as "spacer 150"), metal layers 160 (individually referred to as "metal layer 160"), metal layers 165 (individually referred to as "metal layer 165"), vias 170 (individually referred to as "via 170"), vias 175 (individually referred to as "via 175"), an electrical insulator 180, another electrical insulator 185, and a contact layer 190.

For the purpose of illustration and simplicity, FIG. 1 does not show all components of the IC device 100. The IC device 100 may include fewer, more, or different components. For example, the IC device 100 may include additional semiconductor structures, gates, electrodes, isolation regions, metal layers, vias, or other components not shown in FIG. 1. Also, the shapes, dimensions, and locations of the components of the IC device 100 shown in FIG. 1 are for illustration. The components of the IC device 100 may have different shapes, dimensions, or locations. Connections or electrical coupling between the components of the IC device 100 may also be different.

The semiconductor structures 120 may include one or more semiconductor materials that have crystal structures. A semiconductor structure 120 may be formed through an epitaxial growth process, in which a crystal material may be formed with one or more well-defined orientations with respect to a crystal substrate after the material is deposited onto the crystal substrate. The semiconductor structures 120 may also be referred to as epitaxial structures or epitaxial semiconductor structures. The crystal substrate used for epitaxial growth may be a die or wafer (not shown in FIG. 1). The crystal direction of the epitaxial structures may be determined based on a crystal direction in the crystal substrate.

The semiconductor structures 130 may be semiconductor structures having non-planar shapes. In some embodiments, the semiconductor structures 130 are nanoribbons. A semiconductor structure 130 may have a longitudinal axis along the X axis. The semiconductor structure 130 may also have a transverse cross-section that is perpendicular to the longitudinal axis. The transverse cross-section may be in the Y-Z plane. The dimension of the semiconductor structure 120 along the X axis may be greater (e.g., significantly greater) than the dimension of the semiconductor structure 120 along the Y axis or along the Z axis. In other embodiments, the semiconductor structures 130 may have other non-planar shapes, such as fins. In yet other embodiments, the semiconductor structures 130 may be planar structurers.

In some embodiments, a semiconductor structure 120 is a source region or drain region of a transistor in the IC device 100. Some of the semiconductor structures 130 are channel regions of transistors. In an example, the semiconductor structures 130 that are connected to the semiconductor structurers 120 but are not connected to any of the isolation regions 110 may constitute channel regions of transistors. A channel region may include one or more channel materials. A channel material may be composed of semiconductor material systems including, for example, N-type or P-type materials systems.

In some embodiments, a channel material may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the channel material may include a compound semiconductor with a first sub-lattice of at least one element from Group III of the periodic table (e.g., Al, Ga, In), and a second sub-lattice of at least one element of group V of the periodic table (e.g., P, As, Sb). In some embodiments, the channel material may include a compound semiconductor with a first sub-lattice of at least one element from Group II of the periodic table (e.g., Zn, Cd, Hg), and a second sub-lattice of at least one element of Group IV of the periodic table (e.g., C, Si, Ge, Sn, Pb). In some embodiments, the channel material is an epitaxial semiconductor material deposited using an epitaxial deposition process. The epitaxial semiconductor material may have a polycrystalline structure with a grain size between about 2 nanometers and 100 nanometers, including all values and ranges therein.

For some example N-type transistor embodiments (i.e., for the embodiments where the transistor is an NMOS transistor or an N-type TFET), the channel material may advantageously include a III-V material having a high electron mobility, such as, but not limited to InGaAs, InP, InSb, and InAs. For some such embodiments, the channel material may be a ternary III-V alloy, such as InGaAs, GaAsSb, InAsP, or InPSb. For some InxGa1-xAs fin embodiments, In content (x) may be between 0.6 and 0.9, and may advantageously be at least 0.7 (e.g., In0.7Ga0.3As). In some embodiments with highest mobility, the channel material may be an intrinsic III-V material, i.e., a III-V semiconductor material not intentionally doped with any electrically active impurity. In alternate embodiments, a nominal impurity dopant level may be present within the channel material, for example to further fine-tune a threshold voltage Vt, or to provide HALO pocket implants, etc. Even for impurity-doped embodiments however, impurity dopant level within the channel material may be relatively low, for example below 1015 dopant atoms per cubic centimeter (cm-3), and advantageously below 10¹³ cm⁻³. These materials may be amorphous or polycrystalline, e.g., having a crystal grain size between 0.5 nanometers and 100 nanometers.

For some example P-type transistor embodiments (i.e., for the embodiments where the transistor is a PMOS transistor or a P-type TFET), the channel material may advantageously be a Group IV material having a high hole mobility, such as, but not limited to Ge or a Ge-rich SiGe alloy. For some example embodiments, the channel material may have a Ge content between 0.6 and 0.9, and advantageously may be at least 0.7. In some embodiments with highest mobility, the channel material may be intrinsic III-V (or IV for P-type devices) material and not intentionally doped with any electrically active impurity. In alternate embodiments, one or more nominal impurity dopant levels may be present within the channel material, for example to further set a threshold voltage (Vt), or to provide HALO pocket implants, etc. Even for impurity-doped embodiments however, impurity dopant level within the channel portion is relatively low, for example below 10¹⁵ cm⁻³, and advantageously below 10¹³ cm⁻³. These materials may be amorphous or polycrystalline, e.g., having a crystal grain size between 0.5 nanometers and 100 nanometers.

In some embodiments, the channel material may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, aluminium zinc oxide, or tungsten oxide. In general, for a thin-film transistor (TFT), the channel material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, molybdenum disulfide, N- or P-type amorphous or polycrystalline silicon, monocrystalline silicon, germanium, indium arsenide, indium gallium arsenide, indium selenide, indium antimonide, zinc antimonide, antimony selenide, silicon germanium, gallium nitride, aluminium gallium nitride, indium phosphite, black phosphorus, zinc sulfide, indium sulfide, gallium sulfide, each of which may possibly be doped with one or more of gallium, indium, aluminium, fluorine, boron, phosphorus, arsenic, nitrogen, tantalum, tungsten, and magnesium, etc. In some embodiments, a thin-film channel material may be deposited at relatively low temperatures, which allows depositing the channel material within the thermal budgets imposed on back-end fabrication to avoid damaging other components, e.g., front end components such as logic devices.

As noted above, the channel material may include IGZO. IGZO-based devices have several desirable electrical and manufacturing properties. IGZO has high electron mobility compared to other semiconductors, e.g., in the range of 20-50 times than amorphous silicon. Furthermore, amorphous IGZO (a-IGZO) transistors are typically characterized by high band gaps, low-temperature process compatibility, and low fabrication cost relative to other semiconductors.

IGZO can be deposited as a uniform amorphous phase while retaining higher carrier mobility than oxide semiconductors such as zinc oxide. Different formulations of IGZO include different ratios of indium oxide, gallium oxide, and zinc oxide. One particular form of IGZO has the chemical formula InGaO₃(ZnO)₅. Another example form of IGZO has an indium:gallium:zinc ratio of 1:2:1. In various other examples, IGZO may have a gallium to indium ratio of 1:1, a gallium to indium ratio greater than 1 (e.g., 2:1, 3:1, 4:1, 5:1, 6:1, 7:1, 8:1, 9:1, or 10:1), and/or a gallium to indium ratio less than 1 (e.g., 1:2, 1:3, 1:4, 1:5, 1:6, 1:7, 1:8, 1:9, or 1:10). IGZO can also contain tertiary dopants such as aluminium or nitrogen.

The source region and the drain region of a transistor are connected to the channel region of the transistor. The source region and the drain region may each include a semiconductor material with dopants. In some embodiments, the source region and the drain region have the same semiconductor material, which may be the same as the channel material of the channel region. A semiconductor material of the source region or the drain region may be a Group IV material, a compound of Group IV materials, a Group III/V material, a compound of Group III/V materials, a Group II/VI material, a compound of Group II/Vl materials, or other semiconductor materials. Example Group II materials include zinc (Zn), cadmium (Cd), and so on. Example Group III materials include aluminium (Al), boron (B), indium (In), gallium (Ga), and so on. Example Group IV materials include silicon (Si), germanium (Ge), carbon (C), etc. Example Group V materials include nitrogen (N), phosphorus (P), arsenic (As), antimony (Sb), and so on. Example Group VI materials include sulfur (S), selenium (Se), tellurium (Te), oxygen (O), and so on. A compound of Group IV materials can be a binary compound, such as SiC, SiGe, and so on. A compound of Group III/V materials can be a binary, tertiary, or quaternary compound, such as GaN, InN, and so on. A compound of Group II/Vl materials can be a binary, tertiary, or quaternary compounds, such as CdSe, CdS, CdTe, ZnO, ZnSe, ZnS, ZnTe, CdZnTe, CZT, HgCdTe, HgZnTe, and so on.

In some embodiments, the dopants in the source region and the drain region are the same type. In other embodiments, the dopants of the source region and the drain region may be different (e.g., opposite) types. In an example, the source region has N-type dopants and the drain region has P-type dopants. In another example, the source region has P-type dopants and the drain region has N-type dopants. Example N-type dopants include Te, S, As, tin (Sn), Si, Ga, Se, S, In, Al, Cd, chlorine (CI), iodine (I), fluorine (F), and so on. Example P-type dopants include beryllium (Be), Zn, magnesium (Mg), Sn, P, Te, lithium (Li), sodium (Na), Ga, Cd, and so on.

In some embodiments, the source region and the drain region may be highly doped, e.g., with dopant concentrations of about 1·10²¹ cm⁻³, in order to advantageously form Ohmic contacts with the respective S/D contacts (also sometimes interchangeably referred to as "S/D electrodes"), although these regions may also have lower dopant concentrations and may form Schottky contacts in some implementations. Irrespective of the exact doping levels, the source region and the drain region may be the regions having dopant concentration higher than in other regions, e.g., higher than a dopant concentration in the channel region, and, therefore, may be referred to as "highly doped" (HD) regions.

The channel region may include one or more semiconductor materials with doping concentrations significantly smaller than those of the source region and the drain region. For example, in some embodiments, the channel material of the channel region may be an intrinsic (e.g., undoped) semiconductor material or alloy, not intentionally doped with any electrically active impurity. In alternate embodiments, nominal impurity dopant levels may be present within the channel material, for example to set a threshold voltage Vt, or to provide HALO pocket implants, etc. In such impurity-doped embodiments however, impurity dopant level within the channel material is still significantly lower than the dopant level in the source region and the drain region, for example below 10¹⁵ cm⁻³ or below 10¹³ cm⁻³. Depending on the context, the term "S/D terminal" may refer to a S/D region or a S/D contact or electrode of a transistor.

An electrode 125 over a semiconductor structure 120 be a source electrode or a drain electrode of a transistor. A source electrode is an electrode over a source region. A drain electrode is an electrode over a drain region. The electrode 125 may be coupled to a power source for delivering power to the source or drain region. In some embodiments, the electrodes 125 may be at different electrical potentials during the operation of the IC device. One of the electrodes 125 may be coupled to a power plane, and the other one of the electrodes 125 may be coupled to a ground plane. Each electrode 125 includes one or more electrically conductive materials, such as metals. Examples of metals in the electrode 145A and the electrode 145B may include, but are not limited to, ruthenium (Ru), copper (Cu), cobalt (Co), palladium (Pd), platinum (Pt), nickel (Ni), and so on.

A gate 135 may be over or wrap around at least part of the corresponding semiconductor structures 135. In some embodiments, the gate 135A may be the gate of a transistor in the IC device 100, and the gate 135B may be the gate of another transistor in the IC device 100. The two transistors may be isolated from each other by the isolation regions 110. The two gates 135A and 135B may be functional during operation of the IC device and may be referred to as "functional gates" or "active gates." The semiconductor structures 130 extending across the gate 135A or 135B may be the channel region of the corresponding transistor. The other three gates 135C-135E may be dummy gates, i.e., gates that are not functional. In other embodiments, the IC device 100 may include a different number of functional gates or dummy gates. An active gate may be coupled to a metal layer (e.g., a metal layer 160 or 165), while a dummy gate may be separated from the metal layer by one or more electrical insulators. Even though some of the gates 135 are functional and the others are not functional, each of the five gates 135 has semiconductor structures 130 extending across it. Such a design can result in uniform and continuous semiconductor structures along the X axis and lead to uniformity in the profiles of all the five gates 135.

A gate 135 may include a gate electrode and a gate insulator. The gate electrode can be coupled to a gate terminal that controls gate voltages applied on the transistor. The gate electrode may include one or more gate electrode materials, where the choice of the gate electrode materials may depend on whether the transistor is a P-type transistor or an N-type transistor. For a P-type transistor, gate electrode materials that may be used in different portions of the gate electrode may include, but are not limited to, metal (e.g., ruthenium, palladium, platinum, cobalt, nickel, etc.), conductive metal oxides (e.g., ruthenium oxide, etc.), other types of conductive materials, or some combination thereof. For an N-type transistor, gate electrode materials that may be used in different portions of the gate electrode, but are not limited to, hafnium, zirconium, titanium, tantalum, aluminium, alloys of these metals, and carbides of these metals (e.g., hafnium carbide, zirconium carbide, titanium carbide, tantalum carbide, and aluminium carbide). In some embodiments, the gate electrode may include a stack of a plurality of gate electrode materials, where zero or more materials of the stack are work function materials and at least one material of the stack is a fill metal layer. Further materials/layers may be included next to the gate electrode for other purposes, such as to act as a diffusion barrier layer or/and an adhesion layer. In some embodiments, the gate electrodes of transistors of different types may have different work function materials. For instance, one or more work function materials in the gate electrode of an N-type transistor are different from one or more work function materials in the gate electrode of a P-type transistor.

The gate insulator may wrap around at least part of the gate electrode. The gate insulator separates at least a portion of the channel region from the gate electrode so that the channel region is insulated from the gate electrode. In some embodiments, the gate insulator may wrap around at least a portion of the channel region. The gate insulator may also wrap around at least a portion of the source region or the drain region. At least a portion of the gate insulator may be wrapped around by the gate electrode. The gate insulator includes an electrical insulator, such as a dielectric material, hysteretic material, and so on. Examples of dielectric materials include oxide (e.g., silicon-based oxides, metal oxides, etc.), nitride, carbide, and so on. Examples of hysteretic materials include ferroelectric materials, antiferroelectric materials, etc.

The dielectric structures 127, the electrical insulator 140, and the spacers 150 are electrically insulative. The dielectric structures 127, the electrical insulator 140, and the spacers 150 may include electrical insulators, such as the ones described above. The dielectric structures 127, the electrical insulator 140, and the spacers 150 may separate components in the IC device 100 from each other so that these components are not undesirably coupled to each other. A dielectric structure 127 may surround at least part of a semiconductor structure 130. The dielectric structure 127 may separate the semiconductor structure 130 from the corresponding gate 135. In some embodiments, a dielectric structure 127 may be a gate insulator or part of a gate insulator.

In some embodiments, the dielectric structures 127, the electrical insulator 140, or the spacers 150 may include a dielectric material that is different from the dielectric material(s) in the gate insulator. In an example, a gate insulator may include one or more high-k dielectric materials. The dielectric structures 127, the electrical insulator 140, or the spacers 150 may include one or more low-k dielectric materials. A high-k dielectric material may have dielectric constants higher than the dielectric constant of silicon dioxide. The dielectric constant of silicon dioxide may be approximately 3.9. Examples of high-k dielectric materials include aluminium oxide, zirconium dioxide, hafnium (IV) oxide, silicon nitride, tantalum pentoxide, lead zirconate titanate, and so on. A low-k dielectric material may have dielectric constants lower than the dielectric constant of silicon dioxide. Examples of low-k dielectric materials include silicon-based low-k materials (e.g., fluorine doped silicon dioxide, carbon-doped silicon oxide, silicon oxycarbides, etc.), polymers, silsesquioxane (SSQ)-based materials (e.g., hydrogen-SSQ, methyl-SSQ, etc.), and so on. In some embodiments, the spacers 150 may include the same material as the electrical insulator 140.

Examples of transistors in the IC device 100 may include FET, such as metal-oxide-semiconductor FET (MOSFET), tunnel FET (TFET), fin-based transistor (e.g., FinFET), nanoribbon-based transistor, gate-all-around (GAA) transistor, other types of FET, or some combination thereof. In some embodiments, the IC device 100 may include one or more N-type transistors (e.g., NMOS transistors) and one or more P-type transistors (e.g., PMOS transistors). For instance, the IC device 100 may include a transistor that is arranged over another transistor along the Y axis. The two transistors may be of opposite types. In an example, one of the transistors may be an N-type transistor, while the other transistor is a P-type transistor. The gate of a P-type transistor may include a different work function material from the gate of a N-type transistor. The gates of the two transistors may be over each other in a direction along the Y axis. In some embodiments, the gates may be connected.

The metal layers 160 and 165 are stacked over the semiconductor structures 120 and 130, the electrodes 125, and the gates 135 along the Z axis. In the embodiments of FIG. 1, the metal layers 160 may be frontside metal layers that are arranged at the frontside of the IC device 100, and the metal layers 165 may be backside metal layers that are arranged at the backside of the IC device 100. A metal layer 160 or 165 may include one or more metal lines, which are also referred to as interconnects. A metal line may have a longitudinal axis, which may be along the X axis or Y axis. In some embodiments, the metal lines in the same metal layer 160 or 165 may be in parallel. The metal lines in two adjacent metal layers may be perpendicular to each other. A metal layer 160 or 165 may provide power or signal to an electrode 125 or a gate 135. The metal layers 160 or 165 may be coupled with other devices than transistors, such as diodes, power sources, resistors, capacitors, inductors, sensors, transceivers, receivers, antennas, and so on. The metal layers 160 or 165 may be used to deliver power or signal to such devices. In some embodiments, the metal layer 160 that is closest to the gates 135 may be referred to as M0 or frontside M0, the next metal layer 160 may be referred to as M1 or frontside M1, and so on. The metal layer 165 that is closest to the gates 135 may be referred to as BM0 or backside M0, the next metal layer 160 may be referred to as BM1 or backside M1, and so on. In some embodiment, the dimension of a metal layer 165 along the Z axis is greater than the dimension of a metal layer 160 along the Z axis.

As shown in FIG. 1, the metal layers 160 may be coupled to each other using the vias 170. A via 170 may be connected to two or more metal layers 160 and have a longitudinal axis perpendicular to the metal layers 160. The electrical connections between the metal layers 160 may be different from the electrical connections shown in FIG. 1. Also, even though not shown in FIG. 1, the IC device 100 may include other vias that couple one or more metal layers 160 to an electrode 125 or a gate 135. In an example, an electrode 125 may be coupled to a metal interconnect in the metal layers 160 that functions as a power plane, another electrode 125 may be coupled to a metal interconnect in the metal layers 160 that functions as a ground plane, and a gate 135 may be coupled to a metal interconnect in the metal layers 160 that functions as a signal plane. The metal interconnects for the power plane, ground plane, and signal plane may be separated from each other by the electrical insulator 180. The electrical insulator 180 surrounds the metal layers 160 and vias 170. The electrical insulator 180 may include one or more electrically insulating materials, such as a dielectric material, hysteretic material, and so on.

As shown in FIG. 1, the metal layers 165 may be coupled to each other using the vias 175. A via 175 may be connected to two or more metal layers 165 and have a longitudinal axis perpendicular to the metal layers 165. The electrical connections between the metal layers 165 may be different from the electrical connections shown in FIG. 1. Also, even though not shown in FIG. 1, the IC device 100 may include other vias that couple one or more metal layers 165 to an electrode 125 or a gate 135. In an example, an electrode 125 may be coupled to a metal interconnect in the metal layers 165 that functions as a power plane, another electrode 125 may be coupled to a metal interconnect in the metal layers 165 that functions as a ground plane, and a gate 135 may be coupled to a metal interconnect in the metal layers 165 that functions as a signal plane. The metal interconnects for the power plane, ground plane, and signal plane may be separated from each other by the electrical insulator 185. The electrical insulator 185 surrounds the metal layers 165 and vias 175. The electrical insulator 185 may include one or more electrically insulating materials, such as a dielectric material, hysteretic material, and so on.

The contact layer 190 may facilitate bonding or coupling of the metal layers 160 or the electrical insulator 180 with the rest of the IC device 100. The contact layer 190 may include a bonding material, e.g., glue. In some embodiments, the contact layer 190 may include one or more electrically conductive structures for coupling one or more metal layers 160 to other components of the IC device 100, such as one or more electrodes 125 or gates 135.

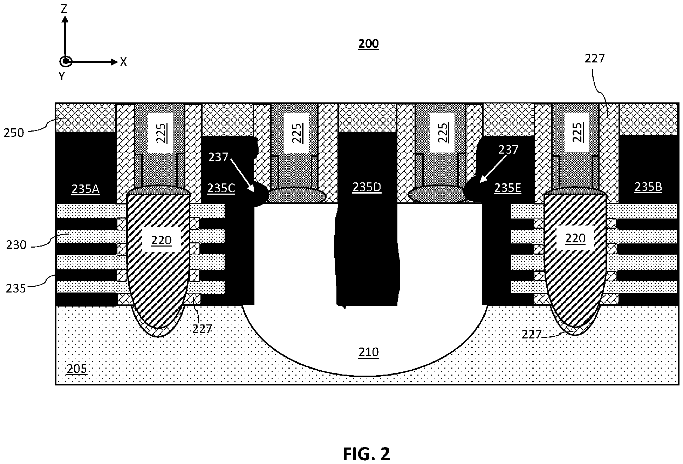

FIG. 2 illustrates an IC device 200 including an isolation region 210 formed through semiconductor cut, according to some embodiments of the disclosure. For the purpose of illustration, FIG. 2 shows a cross-sectional view of the IC device 200 in the X-Z plane. The IC device 200 also includes a support structure 205, semiconductor structures 220 (individually referred to as "semiconductor structure 220"), electrodes 225 (individually referred to as "electrode 225"), dielectric structures 227 (individually referred to as "dielectric structure 227"), semiconductor structures 230 (individually referred to as "semiconductor structure 230"), gates 235A-235E (collectively referred to as "gates 235" or "gate 235"), and spacers 250 (individually referred to as "spacer 250"). For the purpose of illustration and simplicity, FIG. 2 does not show all components of the IC device 200. The IC device 200 may include fewer, more, or different components.

The support structure 205 may be a semiconductor substrate including one or more semiconductor materials. The semiconductor structures 220 and 230 may be formed based on the support structure 205. In some embodiments, the semiconductor structures 220 may be the same or similar as the semiconductor structures 120 in FIG. 1. The electrodes 225 may be the same or similar as the electrodes 125 in FIG. 1. The dielectric structures 227 may be the same or similar as the dielectric structures 127 in FIG. 1. The spacers 250 may be the same or similar as the spacers 150 in FIG. 1.

The semiconductor structures 230 are different from the semiconductor structures 130 in FIG. 1. As described above, the semiconductor structures 130 extends across all the gates 135, while the semiconductor structures 230 do not extend across all the gates 235 due to the semiconductor cut. The semiconductor cut may include semiconductor removal in the isolation region 210. The isolation region 210 may include one or more electrical insulators. Given the semiconductor cut, there are no semiconductor structures 230 in the isolation region 210. Some semiconductor structures 230 are inside a portion of the gate 235C or 235E, but the semiconductor structures 230 do not extend across the entire gate 235C or 235E. Also, no semiconductor structures 230 are inside the gate 235D. The inconsistency in the distribution of the semiconductor structures 230 relative to the gates 235 results in variations in the profiles of the gates 235. As shown in FIG. 2, the gates 235C-235E suffer from gate etch out 237, which causes each of the gates 235C and 235E to contact an electrode 225, resulting in shorts between the gates 235 and the electrodes 225. Also, different from the profiles of the gates 235A and 235B, the profiles of the gates 235C-235E do not have smooth contours. The gate etch out 237 and inconsistency in gate profiles can lead to WID variations and deterioration of the performance of the IC device 200.

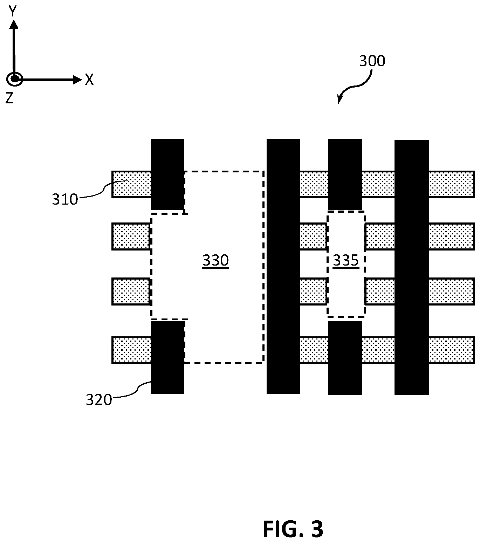

FIG. 3 illustrates an IC device with non-uniform semiconductor structures, according to some embodiments of the disclosure. An example of the IC device 300 may be the IC device 100 in FIG. 1. For the purpose of illustration and simplicity, FIG. 3 shows semiconductor structures 310 (individually referred to as "semiconductor structure 310") and gates 320 (individually referred to as "gate 320") in the IC device 300. The other components of the IC device 300 are not shown in FIG. 3. Also, the IC device 300 may include a different number of semiconductor structure 310 or gate 320.

Each semiconductor structure 310 may include one or more channel materials, such as the channel materials described above in conjunction with FIG. 1. A semiconductor structure 310 may have a non-planar structure, e.g., a fin, nanoribbon, and so on. In some embodiments, a semiconductor structure 310 may have a longitudinal axis along the X axis. The dimension of the semiconductor structure 310 along the X axis may be greater than the dimension of the semiconductor structure 310 along the Y axis or the Z axis. The semiconductor structure 310 may have a traverse cross-section in a Y-Z plane. The traverse cross-section may have the shape of a circle, oval, rectangular, square, and so on.

The gates 320 are over each other in a direction along the X axis. A gate 320 may have a longitudinal axis along the Y axis. The gates 320 have different lengths along the Y axis. In some embodiments, a gate 320 may be an example of gate 135 in FIG. 1. In some embodiments, one or more gates 320 may be functional gates, and the other gate(s) 320 may be dummy gates. A gate 320 may be connected to a via or pin (not shown in FIG. 3) that couples the gate 320 to a metal layer. The via or pin may have a longitudinal axis along the Z axis. The dummy gate(s) in the IC device 300 may be insulated from the metal layer that is coupled to a functional gate in the IC device 300.

The semiconductor structures 310 are not continuous along the X axis due to semiconductor cut in a region 330 and another region 350. The semiconductor cut may remove portions of the semiconductor structures 310 in the regions 330 and 335. In some embodiments, the open space formed by the semiconductor cut may be filled with one or more electrical insulators. The region 330 or the region 350 may be used as isolation regions in the IC device 300. The semiconductor cut can result in variations between the profiles of the gates 320. For instance, the gates that are connected to the region 330 or the region 350 may suffer from gate etch out. The gate etch out may be over the region 330 or the region 350. The gate etch out can result in WID variations and impact the performance of the IC device 300.

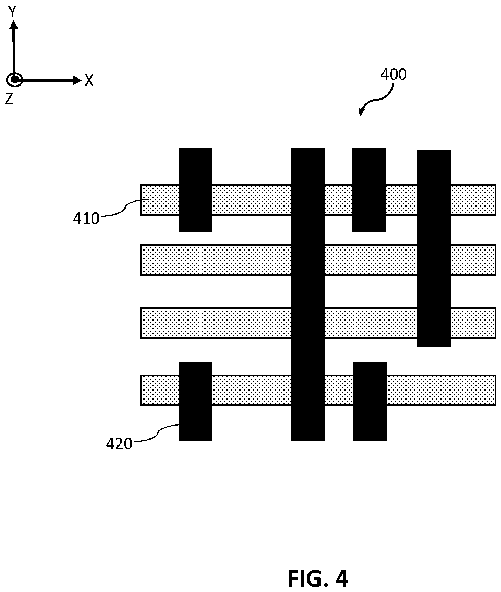

FIG. 4 illustrates an IC device 400 with uniform semiconductor structures, according to some embodiments of the disclosure. An example of the IC device 400 may be the IC device 100 in FIG. 1. For the purpose of illustration and simplicity, FIG. 4 shows four semiconductor structures 410 (individually referred to as "semiconductor structure 410") and six gates 420 (individually referred to as "gate 420") in the IC device 400. The other components of the IC device 400 are not shown in FIG. 4. Also, the IC device 400 may include a different number of semiconductor structure 410 or gate 420.

Each semiconductor structure 410 may include one or more channel materials, such as the channel materials described above in conjunction with FIG. 1. A semiconductor structure 410 may have a non-planar structure, e.g., a fin, nanoribbon, and so on. In some embodiments, a semiconductor structure 410 may have a longitudinal axis along the X axis. The dimension of the semiconductor structure 410 along the X axis may be greater than the dimension of the semiconductor structure 410 along the Y axis or the Z axis. The semiconductor structure 410 may have a traverse cross-section in a Y-Z plane. The traverse cross-section may have the shape of a circle, oval, rectangular, square, and so on. Different from the semiconductor structures 310 in FIG. 3, the semiconductor structures 410 in FIG. 4 are continuous along the X axis. In some embodiments, the semiconductor structures 410 may have the same or substantially similar shape or dimensions.

Each semiconductor structure 410 crosses some or all of the gates 420. The gates 420 are over each other in a direction along the X axis. A gate 420 may have a longitudinal axis along the Y axis. The gates 420 have different lengths along the Y axis. In some embodiments, a gate 420 may be an example of the gates 135 in FIG. 1. In some embodiments, one or more gates 420 may be functional gates, and the other gate(s) 420 may be dummy gates. A gate 420 may be connected to a via or pin (not shown in FIG. 4) that couples the gate 420 to a metal layer. The via or pin may have a longitudinal axis along the Z axis. The dummy gate(s) in the IC device 400 may be insulated from the metal layer that is coupled to a functional gate in the IC device 400.

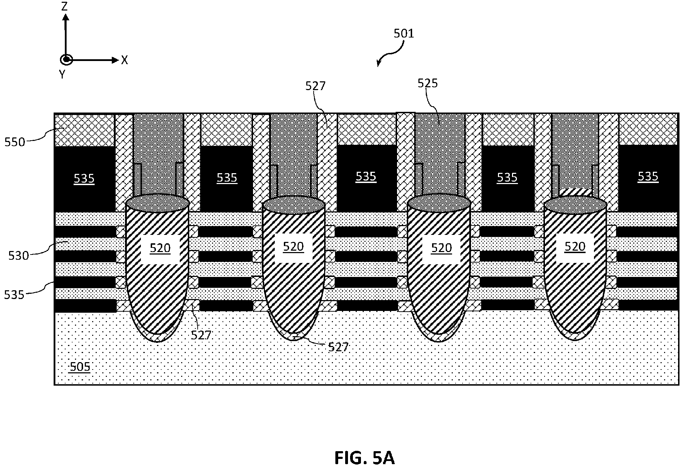

FIGS. 5A-5L illustrate a process of fabricating an IC device 500 with backside isolation regions, according to some embodiments of the disclosure. The IC device 500 may be an example of the IC device 100 in FIG. 1. Although the process is described with reference to the steps shown in FIGS. 5A-5L, many other processes for fabricating IC devices with backside isolation regions may alternatively be used. For example, the order of execution of the steps shown in FIGS. 5A-5L may be changed. As another example, some of the steps may be changed, eliminated, or combined. For the purpose of illustration, some components of the IC device 500 are not shown in FIGS. 5A-5L.

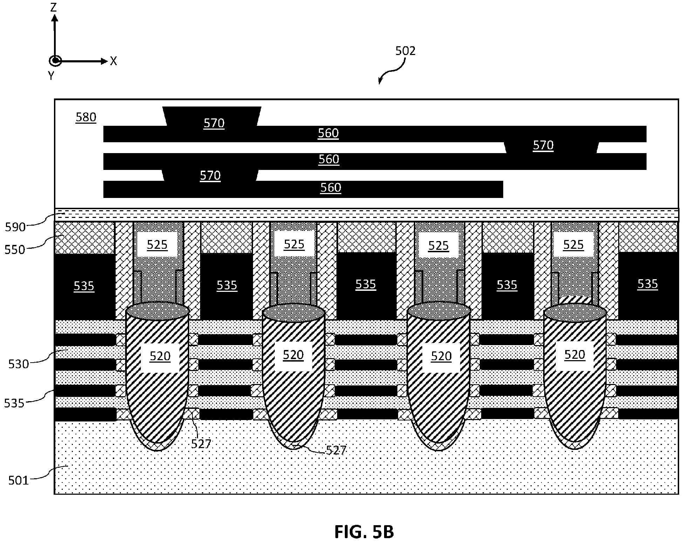

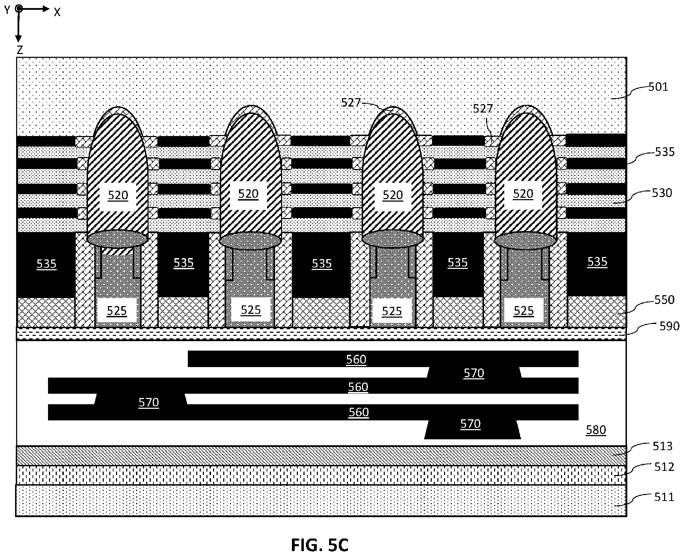

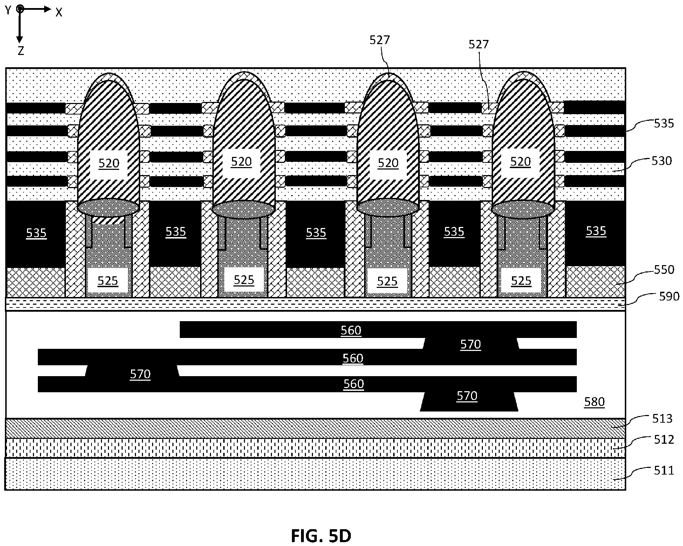

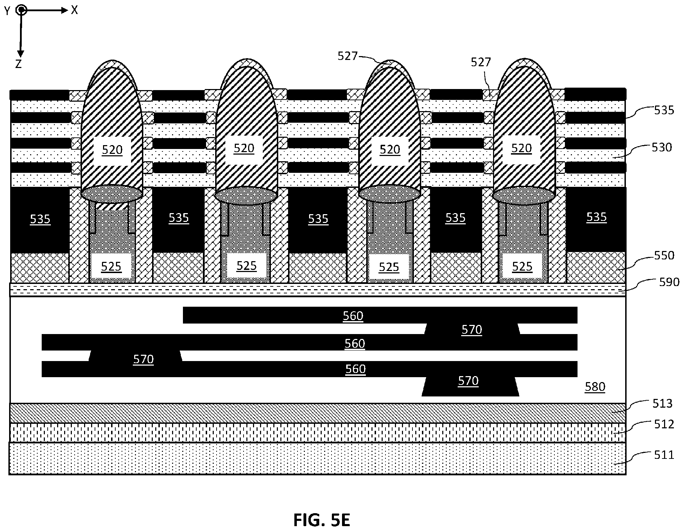

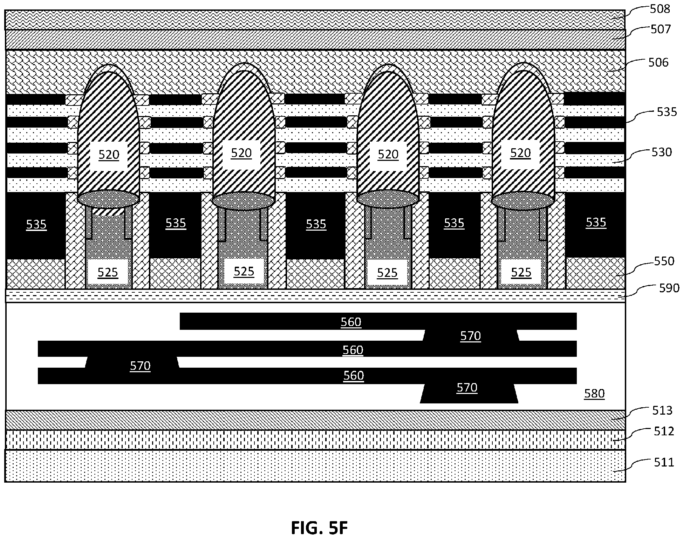

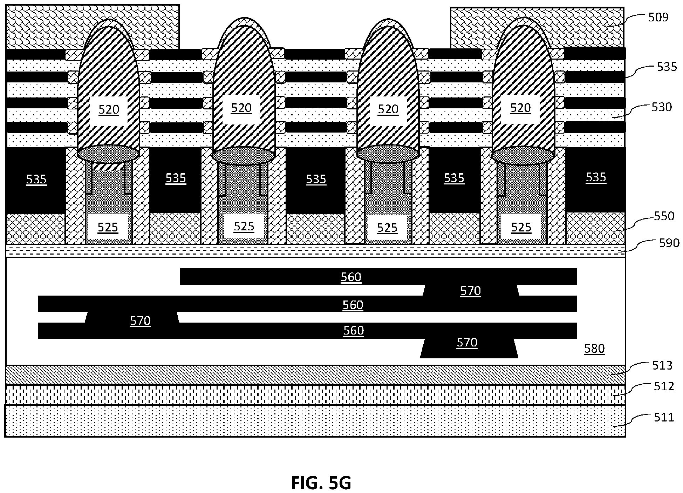

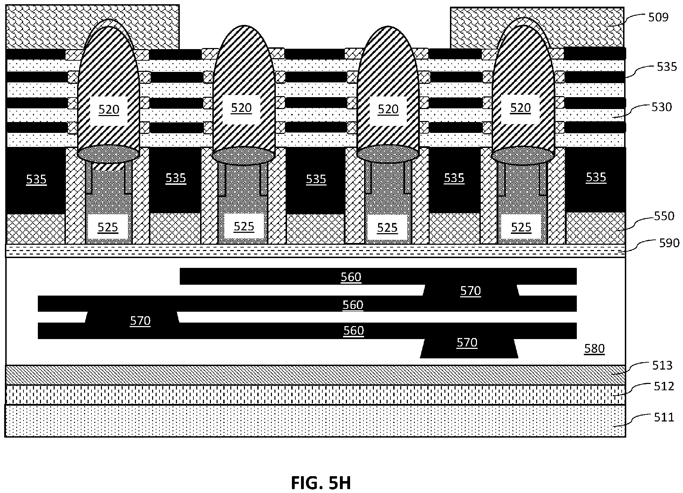

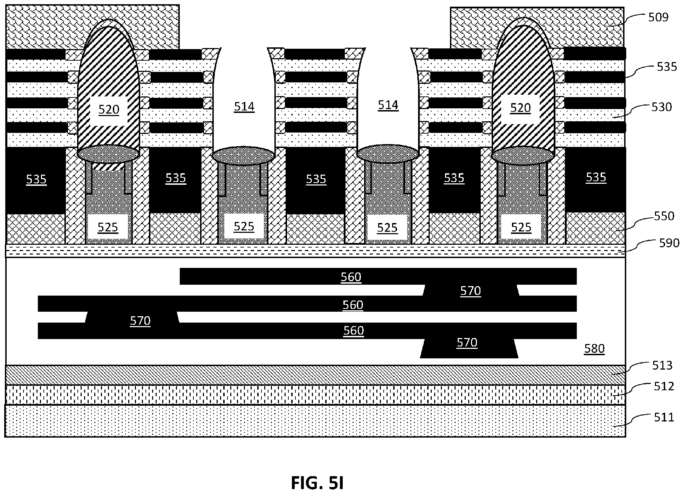

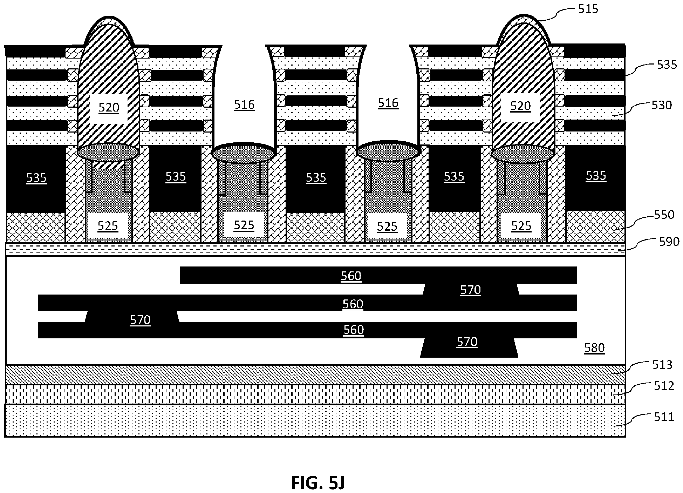

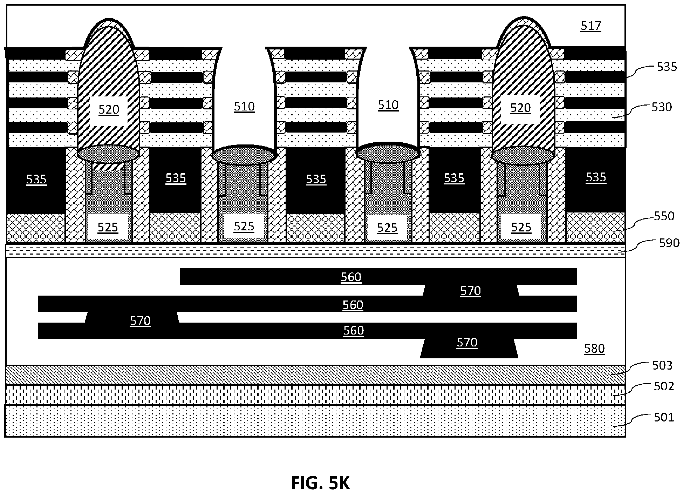

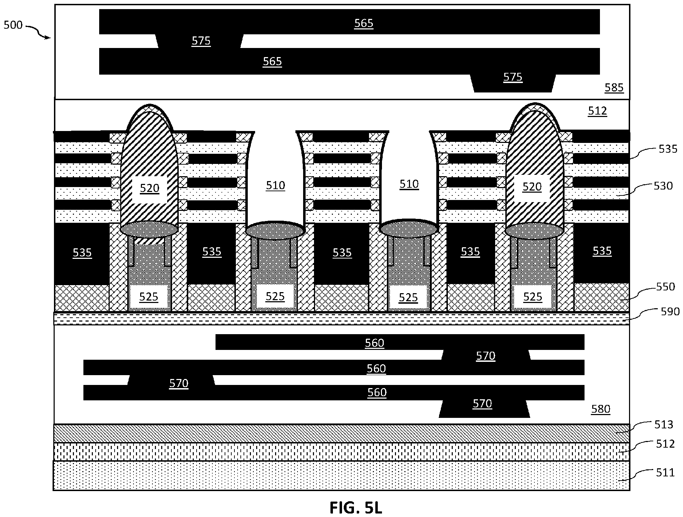

FIG. 5A shows a device 501 that includes a support structure 205, semiconductor structures 520 (individually referred to as "semiconductor structure 520"), electrodes 525 (individually referred to as "electrode 525"), dielectric structures 527 (individually referred to as "dielectric structure 527"), semiconductor structures 530 (individually referred to as "semiconductor structure 530"), gates 535 (individually referred to as "gate 535"), and spacers 550 (individually referred to as "spacer 550"). For the purpose of illustration and simplicity, FIG. 5 does not show all components of the device 501. The device 501 may include more or different components.

The support structure 505 may be any suitable structure, such as a substrate, a die, a wafer, or a chip. The support structure 505 may, e.g., be the wafer 2000 of FIG. 7A, discussed below, and may be, or be included in, a die, e.g., the singulated die 2002 of FIG. 7B, discussed below. Semiconductor devices may be built over the support structure 505. Examples of the semiconductor devices include transistors, resistors, capacitors, and so on. In some embodiments, the support structure 505 may be a semiconductor substrate composed of semiconductor material systems including, for example, N-type or P-type materials systems, and, in some embodiments, the channel region, described herein, may be a part of the support structure 505. In some embodiments, the semiconductor substrate may be a crystalline substrate formed using a bulk silicon or a silicon-on-insulator substructure. In other embodiments, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of Group III-V, Group II-VI, or Group IV materials. In some embodiments, the substrate may be non-crystalline. In some embodiments, the support structure 505 may be a printed circuit board (PCB) substrate. One or more transistors, such as the transistor may be built on the support structure 505.

Although a few examples of materials from which the support structure 505 may be formed are described here, any material that may serve as a foundation upon which an IC may be built falls within the scope of the present disclosure. In various embodiments, the support structure 505 may include any such substrate, possibly with some layers and/or devices already formed thereon, not specifically shown in the present figures. As used herein, the term "support" does not necessarily mean that it provides mechanical support for the IC devices/structures (e.g., transistors, capacitors, interconnects, and so on) built thereon. For example, some other structure (e.g., a carrier substrate or a package substrate) may provide such mechanical support and the support structure 505 may provide material "support" in that, e.g., the IC devices/structures described herein are build based on the semiconductor materials of the support structure 505. However, in some embodiments, the support structure 505 may provide mechanical support.

The semiconductor structures 520 and 530 may be formed based on the support structure 505. In some embodiments, the semiconductor structures 520 may be the same or similar as the semiconductor structures 120 in FIG. 1. The semiconductor structures 530 may be the same or similar as the semiconductor structures 130 in FIG. 1. The electrodes 525 may be the same or similar as the electrodes 125 in FIG. 1. The gates 535 may be the same or similar as the gates 135 in FIG. 1. The dielectric structures 527 may be the same or similar as the dielectric structures 127 in FIG. 1. The spacers 550 may be the same or similar as the spacers 150 in FIG. 1. The device 501 may be formed in FEOL. The device 501 may have a frontside and a backside. The frontside or backside may be the frontside or backside of the support structure 505. In the embodiments of FIGS. 5A-5L, the electrodes 525 and gates 535 are at the frontside of the support structure 505.

In FIG. 5B, metal layers 560, vias 570, an electrical insulator 580, and a contact layer 590 are formed at the frontside of the support structure 505. The device 501 plus the metal layers 560, vias 570, electrical insulator 580, and contact layer 590 constitutes a device 502. The metal layers 560 may be the same or similar as the metal layers 160 in FIG. 1. The vias 570 may be the same or similar as the vias 170 in FIG. 1. The electrical insulator 580 may be the same or similar as the electrical insulator 180 in FIG. 1. The contact layer 590 may be the same or similar as the contact layer 190 in FIG. 1. In some embodiments, the metal layers 560, vias 570, electrical insulator 580, or contact layer 590 may be formed in BEOL.

In FIG. 5C, the device 502 is flipped upside down and bonded to a carrier substrate 511. The carrier substrate 511 may be a semiconductor substrate. In some embodiments, the carrier substrate may include one or more semiconductor materials, which may be the same or similar as the semiconductor material(s) in the support structure 505. The carrier substrate 511 is connected to a bonding layer 512. The bonding layer 512 may include a glue, e.g., an oxide glue. The bonding layer 512 is between the carrier substrate 511 and a layer 513. The layer 513 may include an electrical insulator.

In FIG. 5D, the support structure 505 is removed, e.g., through etching. In FIG. 5E, residual semiconductors surrounding the semiconductor structures 520 (or dielectric structures 527 connected to the semiconductor structures 520) are removed. The residual semiconductors may be removed through further etching.

In FIG. 5F, a layer 506 is formed. The layer 506 may include silicon nitride. The layer 506 is over the semiconductor structures 520 and the gates 535. A layer 507 is formed over the layer 506. The layer 507 may include one or more polymers. In some embodiments, the layer 506 may have a greater mechanical hardness than the layer 507. A layer 508 is formed over the layer 507. The layer 508 may be a resist, e.g., a photoresist. The layer 508 may be patterned via lithography to form a mask.

In FIG. 5G, a mask 509 is formed from the layer 506. The pattern of the masks 509 may be formed using the layer 508. The layers 507 and 508 have been removed. The mask 509 is over two of the semiconductor structures 520 and exposes the other two semiconductor structures 520.

In FIG. 5H, the dielectric structures 527 that are connected to the tip of the two exposed semiconductor structures 520 are removed, e.g., through etching.

In FIG. 5I, the two exposed semiconductor structures 520 are removed and two opening regions 514 (individually referred to as "opening region 514") are formed. The two exposed semiconductor structures 520 are removed through etch, e.g., anisotropic etch. The etch may stop at the edge of the electrodes 525.

In FIG. 5J, the mask 509 is removed. Also, a liner 515 is formed over the exposed surfaces. The liner 515 may be a dielectric layer. In some embodiments, the liner 515 includes a nitride. The liner 515 may be formed by depositing a dielectric material over the exposed surfaces. The opening regions 514 become opening regions 516 (individually referred to as "opening region 516").

In FIG. 5K, an electrical insulator 517 is provided, e.g., through deposition. Part of the electrical insulator 517 is over the liner 515 and fills the opening regions 516 and forms the isolation regions 510.

In FIG. 5L, metal layers 565, vias 575, and electrical insulator 585 are formed at the backside. The metal layers 565 may be the same or similar as the metal layers 165 in FIG. 1. The vias 575 may be the same or similar as the vias 175 in FIG. 1. The electrical insulator 585 may be the same or similar as the electrical insulator 185 in FIG. 1. After the metal layers 565, vias 575, and electrical insulator 585 are formed, the carrier substrate 511, bonding layer 512, and layer 513 may be removed, and the IC device 500 may be flipped back.

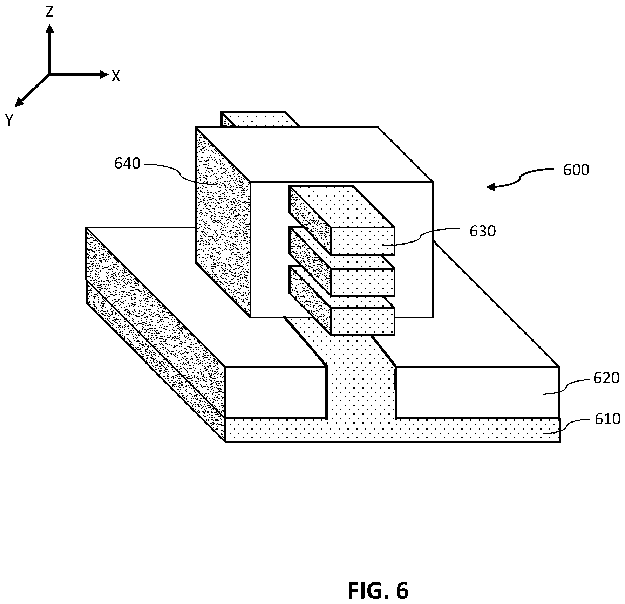

FIG. 6 shows a transistor 600 with nanoribbons 630, according to some embodiments of the disclosure. The nanoribbons 630 (individually referred to as "nanoribbon 630") may be examples of semiconductor structures 130 in FIG. 1, semiconductor structures 410 in FIG. 4, and semiconductor structures 530 in FIGS. 5A-5L. The gate 640 may be an example of the gates 135 in FIG. 1, the gates 420 in FIG. 4, or the gates 535 in 5A-5L. The nanoribbons 630 and gate 640 are over a support structure 610 and a dielectric layer 620.

The support structure 610 may be any suitable structure, such as a substrate, a die, a wafer, or a chip, based on which semiconductor structures (e.g., the nanoribbons 630) can be formed. The support structure 610 may be an embodiment of the support structure 505 in FIG. 5A. The dielectric layer 620 is over various portions of the support structure 610 along the Z axis. The dielectric layer 620 includes one or more dielectric materials, such as the dielectric materials described above.

The nanoribbons 630 are stacked over the support structure 610 along the Z axis. The nanoribbons 630 are arranged parallel to each other. Each nanoribbon 630 may have a longitudinal axis substantially parallel to the Y axis and a transverse cross-section substantially parallel to the X-Z plane. A dimension of a nanoribbon 630 along the Y axis may be greater than a dimension of the nanoribbon 630 in another direction. In other embodiments, each nanoribbon 630 may have a longitudinal axis substantially parallel to the X axis and a transverse cross-section substantially parallel to the Y-Z plane. A dimension of a nanoribbon 630 along the X axis may be greater than a dimension of the nanoribbon 630 in another direction.

The nanoribbons 630 may provide the channel region of the transistor 600. The nanoribbons 630 may include a channel material, such as channel materials described above. Source or drain regions may be formed at ends of the nanoribbons 630. The source or drain regions may be connected to the nanoribbons 630. In some embodiments, a source or drain region may wrap around a portion of a nanoribbon 630. In an example, a source region and a drain region may be formed at opposite sides of the nanoribbons 630. The source region and drain region may each include a semiconductor material with dopants. In some embodiments, the source region and drain region have the same semiconductor material, which may be the same as the channel material of the channel region. In some embodiments, one or more additional gates may wrap around other portions of the nanoribbons 630, and the nanoribbons 630 may provide the channel regions of more transistors.

The dimensions of the nanoribbons 630 may be different for different applications of the transistor 600. For example, compared with embodiments where the transistor 600 is used in a memory die, the cross-section of each nanoribbon 630 in the X-Z plane may be larger when the transistor 600 is used in a logic die. The width of each nanoribbon 630 along the X axis may also be larger when the transistor 600 is used in a logic die. In some embodiments, the transistor 600 may be used in either a logic layer or a memory layer. A nanoribbon transistor in a logic layer may include more nanoribbons (e.g., approximately one to three times more) than a nanoribbon transistor in a memory layer. In some embodiments, the transistor 600 may be a transistor in a logic layer, and a transistor in a memory layer may be a FinFET.

The gate 640 is over the dielectric layer 620. In FIG. 6, the gate 640 wraps around the nanoribbons 630. The gate 640 and the nanoribbons 630 may form one or more GAA transistors. The gate 640 may include a gate electrode including one or more conductive materials, such as metal, polycrystalline silicon, other types of conductive materials, or some combination thereof. In some embodiments, the choice of the conductive materials in the gate 640 may depend on whether the transistor is a P-type transistor or an N-type transistor. For a P-type transistor, gate electrode materials that may be used in different portions of the gate electrode may include, but are not limited to, Ru, palladium, platinum, Co, nickel, and conductive metal oxides (e.g., ruthenium oxide). For an N-type transistor, gate electrode materials that may be used in different portions of the gate electrode, but are not limited to, hafnium, zirconium, titanium, tantalum, aluminium, alloys of these metals, and carbides of these metals (e.g., hafnium carbide, zirconium carbide, titanium carbide, tantalum carbide, and aluminium carbide).

In some embodiments, the gate 640 may include a stack of a plurality of gate electrode materials, where zero or more materials of the stack are work function materials and at least one material of the stack is a fill metal layer. Further materials/layers may be included next to the gate electrode for other purposes, such as to act as a diffusion barrier layer or/and an adhesion layer. The gate 640 may also include a gate insulator, part of which may be between the gate electrode and each nanoribbon 630. The gate 640 may be electrically coupled to a power plane, ground plane, or signal plane for facilitating power supply or signal transmission for the transistor 600.

FIGS. 7A-7B are top views of a wafer 2000 and dies 2002, according to some embodiments of the disclosure. In some embodiments, the dies 2002 may be included in an IC package, according to some embodiments of the disclosure. For example, any of the dies 2002 may serve as any of the dies 2256 in an IC package 2200 shown in FIG. 8. The wafer 2000 may be composed of semiconductor material and may include one or more dies 2002 having IC devices formed on a surface of the wafer 2000. Each of the dies 2002 may be a repeating unit of a semiconductor product that includes any suitable IC (e.g., ICs with isolation regions including semiconductor structures extending across gates as described herein). After the fabrication of the semiconductor product is complete, the wafer 2000 may undergo a singulation process in which each of the dies 2002 is separated from one another to provide discrete "chips" of the semiconductor product. In particular, devices with semiconductor structures extending across gates in isolation regions as disclosed herein may take the form of the wafer 2000 (e.g., not singulated) or the form of the die 2002 (e.g., singulated). The die 2002 may include one or more diodes, one or more transistors as well as, optionally, supporting circuitry to route electrical signals to the III-N diodes with n-doped wells and capping layers and III-N transistors, as well as any other IC components. In some embodiments, the wafer 2000 or the die 2002 may implement an electrostatic discharge (ESD) protection device, a radio frequency front-end device, a memory device (e.g., a static random-access memory device), a logic device (e.g., an AND, OR, NAND, or NOR gate), or any other suitable circuit element. Multiple ones of these devices may be combined on a single die 2002.

FIG. 8 is a side, cross-sectional view of an example IC package 2200 that may include one or more IC devices with backside isolation regions, according to some embodiments of the disclosure. In some embodiments, the IC package 2200 may be a system-in-package (SiP).

As shown in FIG. 8, the IC package 2200 may include a package substrate 2252. The package substrate 2252 may be formed of a dielectric material (e.g., a ceramic, a glass, a combination of organic and inorganic materials, a buildup film, an epoxy film having filler particles therein, etc., and may have embedded portions having different materials), and may have conductive pathways extending through the dielectric material between the face 2272 and the face 2274, or between different locations on the face 2272, and/or between different locations on the face 2274.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The IC package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 8 are solder bumps, but any suitable first-level interconnects 2265 may be used. In some embodiments, no interposer 2257 may be included in the IC package 2200; instead, the dies 2256 may be coupled directly to the conductive contacts 2263 at the face 2272 by first-level interconnects 2265.

The IC package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 8 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

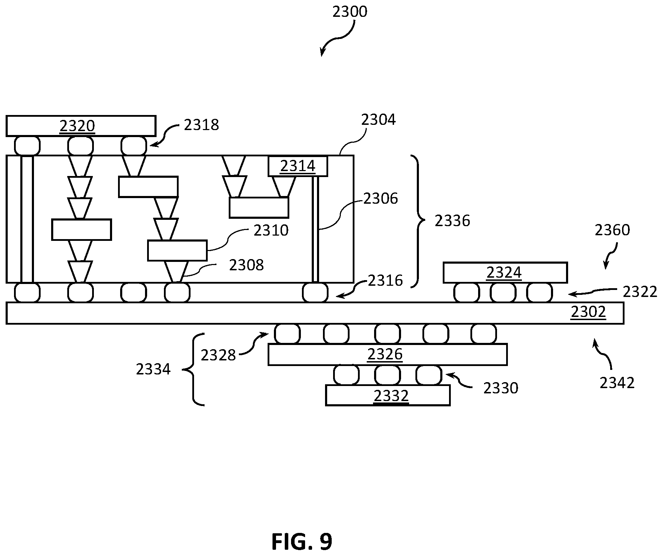

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 8 are solder balls (e.g., for a ball grid array arrangement), but any suitable second-level interconnects 2270 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 9.

The dies 2256 may take the form of any of the embodiments of the die 2002 discussed herein and may include any of the embodiments of an IC device with one or more semiconductor structures extending across a gate in an isolation region. In embodiments in which the IC package 2200 includes multiple dies 2256, the IC package 2200 may be referred to as a multi-chip package. Importantly, even in such embodiments of a multi-chip packaging (MCP) implementation of the IC package 2200, one or more IC devices with backside isolation regions may be provided in a single chip, in accordance with any of the embodiments described herein. The dies 2256 may include circuitry to perform any desired functionality. For example, one or more of the dies 2256 may be ESD protection dies, including one or more IC devices with backside isolation regions as described herein, one or more of the dies 2256 may be logic dies (e.g., silicon-based dies), one or more of the dies 2256 may be memory dies (e.g., high bandwidth memory), etc. In some embodiments, any of the dies 2256 may include or otherwise be associated with one or more components with backside isolation regions, e.g., as discussed above; in some embodiments, at least some of the dies 2256 may not include any III-N diodes with n-doped wells and capping layers.

The IC package 2200 illustrated in FIG. 8 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although two dies 2256 are illustrated in the IC package 2200 of FIG. 8, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

FIG. 9 is a cross-sectional side view of an IC device assembly 2300 that may include components having one or more IC devices with backside isolation regions, according to some embodiments of the disclosure. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of the IC devices with backside isolation regions in accordance with any of the embodiments disclosed herein; e.g., any of the IC packages discussed below with reference to the IC device assembly 2300 may take the form of any of the embodiments of the IC package 2200 discussed above with reference to FIG. 8 (e.g., may include one or more components with backside isolation regions in/on a die 2256).

In some embodiments, the circuit board 2302 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 9 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 9), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 may be or include, for example, a die (the die 2002 of FIG. 7B), an IC device (e.g., the IC devices in FIGS. 1, 4, and 5A-5L), or any other suitable component. In particular, the IC package 2320 may include one or more devices with semiconductor structures extending across gates in isolation regions as described herein. Although a single IC package 2320 is shown in FIG. 9, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 9, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other Group III-V and Group IV materials. The interposer 2304 may include metal interconnects 2308 and vias 2310, including but not limited to TSVs 2306. The interposer 2304 may further include embedded devices 2314, including both passive and active devices. Such devices may include, but are not limited to, capacitors, decoupling capacitors, resistors, inductors, fuses, diodes, transformers, sensors, ESD protection devices, and memory devices. More complex devices such as further RF (radio frequency) devices, power amplifiers, power management devices, antennas, arrays, sensors, and microelectromechanical systems (MEMS) devices may also be formed on the interposer 2304. In some embodiments, the IC devices with backside isolation regions as described herein may also be implemented in/on the interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 9 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

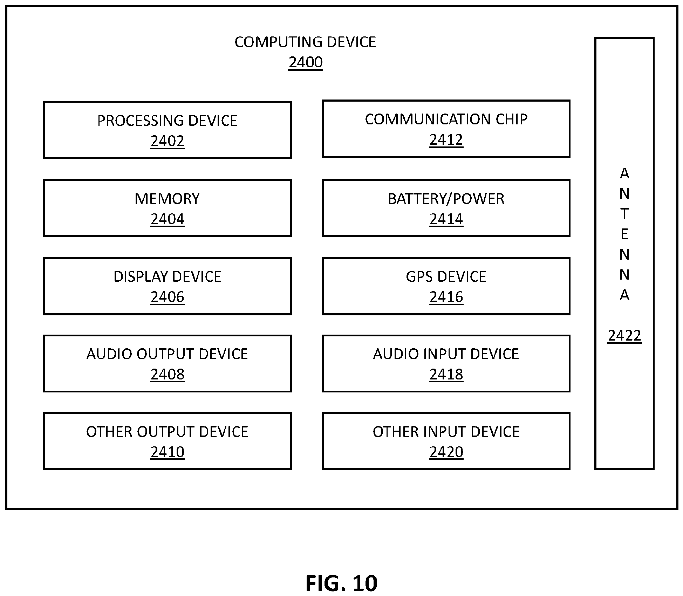

FIG. 10 is a block diagram of an example computing device 2400 that may include one or more components with one or more IC devices with backside isolation regions, according to some embodiments of the disclosure. For example, any suitable ones of the components of the computing device 2400 may include a die (e.g., the die 2002 of FIG. 7B) including or associated with devices with semiconductor structures extending across gates in isolation regions, according to some embodiments of the disclosure. Any of the components of the computing device 2400 may include an IC device with one or more semiconductor structures extending across a gate in an isolation region (e.g., any embodiment of the IC devices described above in conjunction with FIGS. 1, 4, and 5A-5L) and/or an IC package (e.g., the IC package 2200 of FIG. 8). Any of the components of the computing device 2400 may include an IC device assembly (e.g., the IC device assembly 2300 of FIG. 9).

A number of components are illustrated in FIG. 10 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single SoC (system-on-chip) die.

Additionally, in various embodiments, the computing device 2400 may not include one or more of the components illustrated in FIG. 10, but the computing device 2400 may include interface circuitry for coupling to the one or more components. For example, the computing device 2400 may not include a display device 2406, but may include display device interface circuitry (e.g., a connector and driver circuitry) to which a display device 2406 may be coupled. In another set of examples, the computing device 2400 may not include an audio input device 2418 or an audio output device 2408, but may include audio input or output device interface circuitry (e.g., connectors and supporting circuitry) to which an audio input device 2418 or audio output device 2408 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid-state memory, and/or a hard drive. In some embodiments, the memory 2404 may include memory that shares a die with the processing device 2402. This memory may be used as cache memory and may include, e.g., eDRAM, and/or spin transfer torque magnetic random-access memory (STT-MRAM).

In some embodiments, the computing device 2400 may include a communication chip 2412 (e.g., one or more communication chips). For example, the communication chip 2412 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2412 may operate in accordance with other wireless protocols in other embodiments. The computing device 2400 may include an antenna 2422 to facilitate wireless communications and/or to receive other wireless communications (such as AM or FM radio transmissions).

In some embodiments, the communication chip 2412 may manage wired communications, such as electrical, optical, or any other suitable communication protocols (e.g., the Ethernet). As noted above, the communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

In various embodiments, IC devices with backside isolation regions as described herein may be particularly advantageous for use as part of ESD circuits protecting power amplifiers, low-noise amplifiers, filters (including arrays of filters and filter banks), switches, or other active components. In some embodiments, IC devices with backside isolation regions as described herein may be used in PMICs, e.g., as a rectifying diode for large currents. In some embodiments, IC devices with backside isolation regions as described herein may be used in audio devices and/or in various input/output devices.

The computing device 2400 may include battery/power circuitry 2414. The battery/power circuitry 2414 may include one or more energy storage devices (e.g., batteries or capacitors) and/or circuitry for coupling components of the computing device 2400 to an energy source separate from the computing device 2400 (e.g., AC line power).

The computing device 2400 may include a display device 2406 (or corresponding interface circuitry, as discussed above). The display device 2406 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2408 (or corresponding interface circuitry, as discussed above). The audio output device 2408 may include any device that generates an audible indicator, such as speakers, headsets, or earbuds, for example.

The computing device 2400 may include an audio input device 2418 (or corresponding interface circuitry, as discussed above). The audio input device 2418 may include any device that generates a signal representative of a sound, such as microphones, microphone arrays, or digital instruments (e.g., instruments having a musical instrument digital interface (MIDI) output).

The computing device 2400 may include a GPS device 2416 (or corresponding interface circuitry, as discussed above). The GPS device 2416 may be in communication with a satellite-based system and may receive a location of the computing device 2400, as known in the art.

The computing device 2400 may include another output device 2410 (or corresponding interface circuitry, as discussed above). Examples of the other output device 2410 may include an audio codec, a video codec, a printer, a wired or wireless transmitter for providing information to other devices, or an additional storage device.

The computing device 2400 may include another input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

The following paragraphs provide various examples of the embodiments disclosed herein.

Example 1 provides an IC device, including a first transistor including a first semiconductor region, a first electrode over the first semiconductor region in a first direction, and a first gate, in which the first electrode is over the first gate in a second direction that is perpendicular to the first direction; a second transistor including a second semiconductor region, a second electrode over the second semiconductor region in the first direction, and a second gate; an electrical insulator between the first semiconductor region and the second semiconductor region in the second direction; a third electrode over the electrical insulator in the first direction, in which the third electrode is between the first electrode and the second electrode; and a third gate between the electrical insulator and the first semiconductor region in the first direction.

Example 2 provides the IC device according to example 1, further including a first semiconductor structure extending across the first gate; a second semiconductor structure extending across the second gate; and a third semiconductor structure extending across the third gate.

Example 3 provides the IC device according to example 2, in which the first semiconductor region is connected to the first semiconductor structure, and the second semiconductor region is connected to the second semiconductor structure.

Example 4 provides the IC device according to any one of examples 1-3, further including an additional electrical insulator between the first semiconductor region and the second semiconductor region in the second direction; and a fourth electrode over the additional electrical insulator in the first direction, in which the fourth electrode is between the first electrode and the second electrode in the second direction.

Example 5 provides the IC device according to example 4, further including a fourth gate between the electrical insulator and the additional electrical insulator in the second direction; and a fifth gate between the additional electrical insulator and the second semiconductor region in the second direction.

Example 6 provides the IC device according to any one of examples 1-5, further including a metal layer coupled to the first electrode or to the second electrode, the metal layer separated from the third electrode by one or more electrical insulators.

Example 7 provides the IC device according to any one of examples 1-6, further including an additional metal layer, in which the additional metal layer is at a first side of the first transistor or the second transistor, the metal layer is at a second side of the first transistor or the second transistor, and the first side opposes the second side in the first direction.

Example 8 provides an IC device, including a group of conductive structures that are stacked over each other in a first direction; a group of semiconductor structures over each other in a second direction perpendicular to the first direction, a semiconductor structure extending across a conductive structure; an additional semiconductor structure parallel to the conductive structure and connected to the semiconductor structure; a first insulative structure over the semiconductor structure in the second direction; and a second insulative structure over the semiconductor structure in the second direction, in which the second insulative structure is between the first insulative structure and the semiconductor structure.

Example 9 provides the IC device according to example 8, in which another conductive structure is between the first insulative structure and the second insulative structure in the second direction.

Example 10 provides the IC device according to example 9, in which the conductive structure is between the second insulative structure and the additional semiconductor structure in the second direction.

Example 11 provides the IC device according to any one of examples 8-10, further including an electrode connected to the additional semiconductor structure, in which the electrode is over the additional semiconductor structure in the first direction, and at least part of the electrode is over at least part of the conductive structure in the second direction.

Example 12 provides the IC device according to example 11, in which the electrode is a first electrode, and the IC device further includes a second electrode connected to the first insulative structure; and a third electrode connected to the second insulative structure, in which the second electrode and the third electrode are over the first electrode in the second direction.

Example 13 provides the IC device according to any one of examples 8-12, in which the semiconductor structure is a fin or nanoribbon.

Example 14 provides the IC device according to any one of examples 8-13, in which each of the conductive structures is wrapped around by a dielectric layer, and the dielectric layer includes a dielectric material having a dielectric constant that is greater than 3.9.

Example 15 provides a method of forming an IC device, the method including providing a device including a group of conductive structures, a group of semiconductor regions, in which a semiconductor region is between two adjacent conductive structures, and a group of semiconductor structures, one or more semiconductor structures extend across a conductive structure, and a support structure including a semiconductor material; removing the support structure from the device; forming a mask over the device after the support structure is removed, the mask blocking one or more semiconductor regions and exposing one or more other semiconductor regions; removing the one or more other semiconductor regions to form one or more opening regions; and providing an electrical insulator, one or more portions of the electrical insulator filling the one or more opening regions.

Example 16 provides the method according to example 15, further including before the support structure is removed, forming a metal layer at a side of the conductive structures.

Example 17 provides the method according to example 16, further including after the electrical insulator is provided, forming an additional metal layer at another side of the conductive structures that opposes the side of the conductive structures.

Example 18 provides the method according to example 17, in which the device further includes a group of electrodes, an electrode is connected to a semiconductor region, and the method further includes coupling the electrode to the additional metal layer.

Example 19 provides the method according to any one of examples 15-18, further including before the support structure is removed, placing the device over an additional support structure, in which the conductive structures are between the support structure and an additional support structu re.

Example 20 provides the method according to example 19, further including before the device is placed over the additional support structure, flipping the device upside down.

Example 21 provides an IC package, including the IC device according to any one of examples 1-20; and a further IC component, coupled to the device.

Example 22 provides the IC package according to example 21, where the further IC component includes one of a package substrate, an interposer, or a further IC die.

Example 23 provides the IC package according to example 21 or 22, where the IC device according to any one of examples 1-20 may include, or be a part of, at least one of a memory device, a computing device, a wearable device, a handheld electronic device, and a wireless communications device.

Example 24 provides an electronic device, including a carrier substrate; and one or more of the IC devices according to any one of examples 1-20 and the IC package according to any one of examples 21-23, coupled to the carrier substrate.

Example 25 provides the electronic device according to example 24, where the carrier substrate is a motherboard.

Example 26 provides the electronic device according to example 24, where the carrier substrate is a PCB.

Example 27 provides the electronic device according to any one of examples 24-26, where the electronic device is a wearable electronic device or handheld electronic device.

Example 28 provides the electronic device according to any one of examples 24-27, where the electronic device further includes one or more communication chips and an antenna.

Example 29 provides the electronic device according to any one of examples 24-28, where the electronic device is an RF transceiver.

Example 30 provides the electronic device according to any one of examples 24-28, where the electronic device is one of a switch, a power amplifier, a low-noise amplifier, a filter, a filter bank, a duplexer, an upconverter, or a downconverter of an RF communications device, e.g., of an RF transceiver.

Example 31 provides the electronic device according to any one of examples 24-30, where the electronic device is a computing device.

Example 32 provides the electronic device according to any one of examples 24-31, where the electronic device is included in a base station of a wireless communication system.

Example 33 provides the electronic device according to any one of examples 24-31, where the electronic device is included in a user equipment device of a wireless communication system.

Example 34 provides processes for forming the IC device according to any one of claims 1-20.

Example 35 provides processes for forming the IC package according to any one of the claims 21-23.

Example 36 provides processes for forming the electronic device according to any one of the claims 24-33.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device, comprising:
a first transistor comprising a first semiconductor region, a first electrode over the first semiconductor region in a first direction, and a first gate, wherein the first electrode is over the first gate in a second direction that is perpendicular to the first direction;
a second transistor comprising a second semiconductor region, a second electrode over the second semiconductor region in the first direction, and a second gate;
an electrical insulator between the first semiconductor region and the second semiconductor region in the second direction;
a third electrode over the electrical insulator in the first direction, wherein the third electrode is between the first electrode and the second electrode; and
a third gate between the electrical insulator and the first semiconductor region in the first direction.

2. The IC device according to claim 1, further comprising:
a first semiconductor structure extending across the first gate;
a second semiconductor structure extending across the second gate; and
a third semiconductor structure extending across the third gate,
wherein the first semiconductor region is connected to the first semiconductor structure, and the second semiconductor region is connected to the second semiconductor structure.

3. The IC device according to claim 1 or 2, further comprising:
an additional electrical insulator between the first semiconductor region and the second semiconductor region in the second direction; and
a fourth electrode over the additional electrical insulator in the first direction, wherein the fourth electrode is between the first electrode and the second electrode in the second direction.

4. The IC device according to claim 3, further comprising:
a fourth gate between the electrical insulator and the additional electrical insulator in the second direction; and
a fifth gate between the additional electrical insulator and the second semiconductor region in the second direction.

5. The IC device according to any one of claims 1-4, further comprising:
a metal layer coupled to the first electrode or to the second electrode, the metal layer separated from the third electrode by one or more electrical insulators; or
an additional metal layer, wherein the additional metal layer is at a first side of the first transistor or the second transistor, the metal layer is at a second side of the first transistor or the second transistor, and the first side opposes the second side in the first direction.

6. An integrated circuit (IC) device, comprising:
a group of conductive structures that are stacked over each other in a first direction;
a group of semiconductor structures over each other in a second direction perpendicular to the first direction, a semiconductor structure extending across a conductive structure;
an additional semiconductor structure parallel to the conductive structure and connected to the semiconductor structure;
a first insulative structure over the semiconductor structure in the second direction; and
a second insulative structure over the semiconductor structure in the second direction, wherein the second insulative structure is between the first insulative structure and the semiconductor structure.

7. The IC device according to claim 6, wherein another conductive structure is between the first insulative structure and the second insulative structure in the second direction, or the conductive structure is between the second insulative structure and the additional semiconductor structure in the second direction.

8. The IC device according to claim 6 or 7, further comprising:
an electrode connected to the additional semiconductor structure, wherein the electrode is over the additional semiconductor structure in the first direction, and at least part of the electrode is over at least part of the conductive structure in the second direction.

9. The IC device according to claim 8, wherein the electrode is a first electrode, and the IC device further comprises:
a second electrode connected to the first insulative structure; and
a third electrode connected to the second insulative structure,
wherein the second electrode and the third electrode are over the first electrode in the second direction.

10. The IC device according to any one of claims 6-9, wherein:
the semiconductor structure is a fin or nanoribbon; or
each of the conductive structures is wrapped around by a dielectric layer, and the dielectric layer comprises a dielectric material having a dielectric constant that is greater than 3.9.

11. A method of forming an integrated circuit (IC) device, the method comprising:
providing a device comprising:
a group of conductive structures,
a group of semiconductor regions, wherein a semiconductor region is between two adjacent conductive structures,
and a group of semiconductor structures, one or more semiconductor structures extend across a conductive structure, and
a support structure comprising a semiconductor material;
removing the support structure from the device;
forming a mask over the device after the support structure is removed, the mask blocking one or more semiconductor regions and exposing one or more other semiconductor regions;
removing the one or more other semiconductor regions to form one or more opening regions; and
providing an electrical insulator, one or more portions of the electrical insulator filling the one or more opening regions.

12. The method according to claim 11, further comprising:
before the support structure is removed, forming a metal layer at a side of the conductive structures; and
after the electrical insulator is provided, forming an additional metal layer at another side of the conductive structures that opposes the side of the conductive structures.

13. The method according to claim 12, wherein the device further comprises a group of electrodes, an electrode is connected to a semiconductor region, and the method further comprises:
coupling the electrode to the additional metal layer.

14. The method according to any one of claims 11-13, further comprising:
before the support structure is removed, placing the device over an additional support structure, wherein the conductive structures are between the support structure and an additional support structure.

15. The method according to claim 14, further comprising:
before the device is placed over the additional support structure, flipping the device upside down.
